# EUROPEAN PATENT APPLICATION

(11) **EP 1 526 408 A1**
(43) Date of publication of application: **27.04.2005**
(21) Application number: 04077885.4
(22) Date of filing: 20.10.2004
(51) Int. Cl.: G03F 7/20

(54) **Lithographic apparatus and device manufacturing method, and measurement systems**

(30) Priority: 22.10.2003 EP 03078338
(71) Applicant: ASML Netherlands B.V., 5504 DR Veldhoven (NL)
(72) Inventor: Beems, Marcel Hendrikus Maria, 5508 EK Veldhoven (NL); Van der Pasch, Engelbertus Antonius Fransiscus, 5688 EG Oirschot (NL)
(74) Representative: Barendregt, Frank, Drs.

(57) **Abstract**

The invention pertains to a lithographic apparatus comprising a radiation system for providing a projection beam of radiation; a projection system for projecting the projection beam onto a target portion of a substrate; a moveable object; displacement means for moving the moveable object relative to the projection system in substantially a first direction and a second direction differing from the first direction; and measuring means for measuring a displacement of the moveable object in a third direction, which is substantially perpendicular to the first direction and to the second direction.

The lithographic apparatus according to the invention is characterized in that the measuring means comprises an encoder system.

## Description

The present invention relates to a lithographic apparatus comprising:
- a radiation system for providing a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The invention also relates to a measurement system.

The term "patterning means " as here employed should be broadly interpreted as referring to means that can be used to endow an incoming radiation beam with a patterned cross-section, corresponding to a pattern that is to be created in a target portion of the substrate; the term "light valve " can also be used in this context. Generally, said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such a device is that, for example, addressed areas of the reflective surface reflect incident light as diffracted light, whereas unaddressed areas reflect incident light as undiffracted light. Using an appropriate filter, said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors and unaddressed mirrors will reflect an incoming radiation beam in different directions; in this manner, the reflected beam is patterned according to the addressing pattern of the matrix-addressable mirrors. The required matrix-addressing can, for example, be performed using suitable electronic means. In both of the situations described hereabove, the patterning means can comprise one or more programmable mirror arrays. More information on mirror arrays as here referred to can be gleaned, for example, from United States Patents US 5, 296, 891 and US 5, 523,193, and PCT patent applications WO 98/38597 and WO 98/33096, which are incorporated herein by reference. In the case of a programmable mirror array, said support structure may be embodied as a frame or table, for example, which may be fixed or movable as required; and
- A programmable liquid crystal display (LCD) panel. An example of such a device is given in United States Patent US 5,229,872, which is incorporated herein by reference. As above, the support structure in this case may be embodied as a frame or table, for example, which may be fixed or movable as required.
   For purposes of simplicity, the rest of this text may, at certain locations, specifically direct itself to examples involving a mask and mask table; however, the general principles discussed in such instances should be seen in the broader context of the patterning means as hereabove set forth.
   Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic apparatus as here described can be gleaned, for example, from US 6,046,792, incorporated herein by reference.
   In a device manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurementl/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference. For the sake of simplicity, the projection system may hereinafter be referred to as the "lens"; however, this term should be broadly interpreted as encompassing various types of projection system, including refractive optics, reflective optics, and catadioptric systems, for example, whereby any of these types of projection system may either be suitable for conventional imaging or be suitable for imaging in the presence of an immersion fluid. The radiation system may also include components operating according to any of these design types for directing, shaping, or controlling the projection beam of radiation, and such components may also be referred to below, collectively or singularly, as a "lens". Further, the lithographic apparatus may be of a type having two or more substrate tables (and/or two or more mask tables). In such "multiple stage" machines the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

The operational sequence of a lithographic apparatus comprises a projection phase, in which the projection system is active. During a projection cycle, a single substrate, such as a wafer plate, is exposed. The projection cycle takes place during the projection phase of the operational sequence.

During the projection phase, the projection beam has to move over the surface of the substrate. Also, the patterning means has to be moved relative to the projection beam. This is achieved by using a stationary projection system, relative to which the substrate and the patterning means are moved.

The substrate is carried on a substrate table, such as a wafer stage. The substrate table is moveable in a substrate table x-y-plane parallel to the plane of the substrate, which during the projection phase is substantially perpendicular to the direction of the projection beam. The plane of the substrate is referred to as the substrate x-y-plane. The substrate table x-direction and the substrate table y-direction are both defined in the substrate table x-y-plane. They are perpendicular to each other, and represent the main translational directions of movement of the substrate table. The direction perpendicular to the substrate table x-y-plane is referred to as the substrate table z-direction.

The patterning means is carried on a reticle stage. The reticle stage is moveable in a reticle stage x-y-plane parallel to the plane of the patterning means, which during the projection phase is substantially perpendicular to the direction of the projection beam. The plane of the patterning means is referred to as the reticle x-y-plane. The reticle stage x-direction and the reticle stage y-direction are both defined in the reticle stage x-y-plane. They are perpendicular to each other, and represent the main translational directions of movement of the reticle stage. The direction perpendicular to the reticle stage x-y-plane is referred to as the reticle stage z-direction.

In general, the substrate table x-y-plane and the reticle stage x-y-plane are substantially parallel, so the substrate table z-direction is substantially equal to the reticle stage z-direction. Usually, the reticle stage y-direction is defined as the direction of the long stroke movement of the reticle stage. In general, the substrate table y-direction will be parallel to the reticle stage y-direction and the substrate table x-direction will be parallel to the reticle stage x-direction.

The lithographic process requires that the image projected onto the substrate is very accurate. In order to achieve this, the displacements of both the substrate table and the reticle stage have to be known very accurately. This not only pertains to the displacements of the substrate table and the reticle stage in their respective x-y-planes, but also to their displacements in their respective z-directions. In known lithographic apparatus, the displacements of the substrate table and the reticle stage in all six degrees of freedom are measured during the projection phase. Generally, the measurement signals resulting from the displacement measurements are used to control the position and the movements of the substrate table and the reticle stage, respectively.

In general, during the projection phase, the displacement of the substrate table in its x-y-plane is far larger than its displacement in its z-direction. The displacement of the reticle stage in its respective y-direction is far larger than its displacements in its x-and z-directions.

In known lithographic apparatus, interferometers are often used for measuring displacements of the substrate table and/or the reticle stage, for example for measuring the displacements of the substrate table in z-direction. However, due to current developments, the layout of the substrate table and the projections change in such a way that it is envisaged that within some time the current interferometer system for measuring the displacements in z-direction of the substrate table can no longer be used.

Recently, it has been proposed to replace some of the interferometers used for measuring the x- and y- positions of the substrate table and the reticle stage with encoder systems. However, such known encoder systems require a more or less constant distance between the sensor head and the moveable object (such as the substrate table or the reticle stage) of which the displacement is to be measured, allowing variations in the order of magnitude of 1 mm. As the substrate table performs movements significantly larger than 1 mm in its x- and y-directions and the reticle stage performs movements significantly larger than 1 mm in at least its y-direction, known encoder systems are not suitable for the purpose of measuring z-displacements of the substrate table and/or the reticle stage.

It is an object of the invention to provide a measurement system for measuring a displacement in a third direction of a moveable object, which moveable object is adapted to move in a first direction and a second direction differing from the first direction, which third direction is substantially perpendicular to the first direction and to the second direction, which measurement system is suitable for use in future lithographic apparatus. Preferably, the measurement system is suitable for measuring a displacement of the substrate table in the substrate table z- direction and for measuring a displacement of the reticle stage in the reticle stage z-direction.

Preferably, the weight of parts of the measuring system that are mounted onto moving parts of the lithographic apparatus are reduced in weight compared to the weight of parts of the known measuring system that are mounted onto moving parts of the lithographic apparatus.

In a first aspect of the invention, this and other objects are achieved according to the invention in a lithographic apparatus according to claim 1.

According to the first aspect of the invention, a lithographic apparatus is provided with measuring means for measuring a displacement in a third direction of a moveable object, which moveable object is adapted to move in a first direction and a second direction differing from the first direction, which third direction is substantially perpendicular to the first direction and to the second direction, such as the respective z-displacements of the substrate table and/or the reticle stage, which measuring means comprise an encoder system.

The advantage of using an encoder system for measuring the displacement of moveable objects such as the substrate table in its z-direction is that it is suitable for use in future lithographic systems. It is envisaged that future lithographic systems have a relatively small substrate table and a relatively large projection system. Moreover, an encoder system takes a little space near the moveable object and it adds less weight to the moveable object then known systems for measuring the displacement of the moveable object in its z-direction. It is suitable for use on the reticle stage and on the substrate table.

Preferably, the encoder system uses a principle similar to known encoder systems.-It has been found that the principle of known encoder systems can be made suitable for measuring displacements in a third direction of moveable objects having large displacements in a first and a second direction, the first and the second direction being perpendicular to the third direction and at least substantially perpendicular to each other, so that it is suitable for measuring the displacements of the substrate table or the reticle stage in its respective z-direction while the substrate table or the reticle stage respectively makes relatively large movements in its respective x-y-plane, such as during the projection phase or stepping phase. For the sake of clarity, the first direction will be indicated as the x-direction, the second direction as the y-direction and the third direction as the z-direction.

In the description of the preferred encoder system, the words "right" and "left" are often used. They should not be read as defining relative positions or a spatial orientation of the elements they refer to; the words "right" and "left" are solely used to distinguish between the different elements or features. The same applies to the "first order beam" and the "minus first order beam"; the words are solely used to be able to distinguish between the two beams resulting from a beam passing through a grating.

The preferred encoder system comprises a beam source, which generates a first beam. The first beam is a polarized beam of radiation such as a laser beam. When the measuring means is active, the first beam is directed towards the moveable object, and more in particular to a reflective first grating, which is fixed onto the moveable object. Alternatively, the first beam can be directed from the moveable object to a first grating that is stationary mounted apart form the moveable object. Preferably, the first beam is directed in the moveable object's x-y-plane, or in a plane parallel to this plane. More preferable, the first beam is directed in the moveable object's x-direction or the moveable object's y-direction.

The first grating comprises parallel lines, running into a plane perpendicular to the direction of the first beam. The parallel lines of the grating are equidistantially spaced from each other in the moveable object's z-direction. For example, when the first beam runs in the moveable object's x-direction, the parallel lines run parallel to the moveable object' s y-direction in the moveable object's y-z-plane. Typically, the distance between subsequent lines, which distance is called the grating period, is about 10 µm.

The length of the parallel lines is chosen such that the first beam touches them during the entire projection process irrespective of the location of the moveable object. Preferably, the parallel lines extend over the entire width of the moveable object, preferably in the x- or y-direction. The first grating breaks the first beam into at least a second beam, which is the first order beam of the first beam and a third beam which is the minus first order beam of the first beam.

As the first beam moves over the grating in the moveable object's z-direction due to movement of the moveable object in its z-direction, a first phase shift occurs in the second beam relative to the first beam and a second phase shift occurs in the third beam relative to the first beam. The first and the second phase shifts are equal in size but opposite in sign.

The second beam is directed to a right second grating, which breaks the second beam into at least a fourth beam, which is the first order beam of the second beam and a fifth beam which is the minus first order beam of the second beam. The parallel lines of the right second grating run parallel to the lines of the first grating.

The third beam is directed to a left second grating, which breaks the third beam into at least a sixth beam, which is the minus first order beam of the third beam and a seventh beam which is the first order beam of the third beam. Also, the lines of the left second grating run parallel to the lines of the first grating.

Both the right second grating and the left second grating are transmissive gratings.

The second gratings are arranged on opposite sides of the beam source. This way it is achieved that the encoder system is less sensitive to changes in the distance between the moveable object and the beam source in the direction of the first beam.

The angle between the first beam and the second beam and the angle between the first beam and the third beam are equal in size but different in sign. The size of the angle is determined by the distance between the lines of the grating, so that it is not affected by the displacement of the moveable object relative to the beam source. When the moveable object moves away from the beam source, the location where the second beam touches the right second grating moves further away from the beam source (that is: to the right, as seen in the direction of the second beam). Also, the location where the third beam touches the left second grating; moves further away from the beam source (that is: to the left, as seen in the direction of the third beam). As the angle between the first beam and the second beam and the angle between the first beam and the third beam are equal in size, the displacement of the location in which the second beam touches the right second grating is equal in size to the displacement of the location in which the third beam touches the left second grating, but opposite in direction. Adding these displacements to each other results in zero, so no net effect takes place. This way, the measured data is relatively insensitive to changes in the distance between the moveable object and the beam source.

The grating period of the first grating is chosen such that the angle between the first beam and the second beam and the angle between the first beam and the third beam are relatively small compared to known encoders of this type. Preferably, these angles are between 3° and 6°. This way, the displacement of the irradiated location (that is:
where the beam touches the grating) on the second gratings is relatively small when the distance between the moveable object and the beams source changes. This way, the length of the second gratings measured in the direction of the parallel lines can be kept relatively small.

The fourth beam then meets a right roof prism, which directs the fourth beam in the direction opposite to the direction of the second beam, and at a offset distance from the second beam. In the same way, the sixth beam then meets a left roof prism, which directs the sixth beam in the direction opposite to the direction of the third beam, and at an offset distance from the third beam. The left and right roof prism could each (or both) be replaced by a set of reflecting surfaces, which are preferable at an angle of 90° to each other, thus in fact creating the function of the roof prism by using multiple elements.

From the right roof prism, the fourth beam is directed to a right λ/4-plate, which is an anisotropic optical element. The right λ/4 plate turns the linear polarization into a circular polarization of the fourth beam. In the same way, the sixth beam is directed to a left λ/4-plate, which also is an anisotropic optical element. The left λ/4 plate turns the linear polarization into a circular polarization of the sixth beam.

The fourth beam then reaches a right third grating, which breaks the fourth beam into at least an eighth beam, which is the first order beam of the fourth beam and a ninth beam which is the minus first order beam of the fourth beam. In the same way, the sixth beam then reaches a left third grating, which breaks the sixth beam into at least a tenth beam, which is the minus first order beam of the sixth beam and an eleventh beam which is the first order beam of the sixth beam.

The third gratings are arranged on opposite sides of the beam source, in such a way that they are arranged aligned with the second gratings. Each of the third gratings is a transmissive grating.

The eighth beam is then received by a fourth grating, which breaks the eighth beam into at least a twelfth beam, which is the first order beam of the eighth beam and a thirteenth beam which is the minus first order beam of the eighth beam. The fourth grating also receives the tenth beam and breaks the tenth beam into at least a fourteenth beam, which is the minus first order beam of the tenth beam and a fifteenth beam which is the first order beam of the tenth beam.

The fourth grating, which is a reflective grating, is arranged aligned and preferably integrated with the first grating, in such a way that the distance between the fourth grating and the third grating substantially equals the distance between the first grating and the second gratings, so that the eighth beam and the tenth beam strike the fourth grating at substantially the same location so that interference between the twelfth beam and the fourteenth beam occurs.

The measuring means further comprises a sensor unit, for sensing variations in radiation intensity of the interfering twelfth beam and the fourteenth beam, and linking said variations to a phase shift that occurs when the first and the second grating are displaced substantially perpendicular to the first beam and the grating lines.

The measuring means which is described above can be used in a lithographic apparatus for measuring the displacement of the reticle stage in the reticle stage z-direction, and for measuring the displacement of the substrate table in the substrate table z-direction, for example during projection and/or during stepping. When using this system, the displacements in z-direction can be measured accurately in spite of the far larger displacements in the y-direction or the x-y-plane.

Preferably, the first grating and the second grating are integrated into a single ruler, which is mounted on the moveable object. Preferably, the ruler is glued to the moveable object. An other advantageous option is to print the ruler onto the moveable object.

Preferably, the right second grating and the right third grating are integrated into a single right ruler, and the left second grating and the left third grating are integrated into a single left ruler.

Preferably, the encoder system comprises an encoder head, in which at least the beam source, the right and left second gratings, the right and left roof prisms, the right and left λ/4-plates and the right and left third gratings are accommodated. Note that according to an aspect of the invention the right and left λ/4-plates can be combined to one λ/2-plate.

According to a first further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material;
- providing a moveable object;
- moving the moveable object relative to the projection system in substantially a first direction and a second direction differing from the first direction, by using displacement means;
- measuring a displacement of the moveable object in a third direction, which is substantially perpendicular to the first direction and to the second direction by using measuring means,
characterized by using measuring means comprising an encoder system.

In a second aspect of the invention, the objects of the invention and other objects are achieved according to the invention in a lithographic apparatus according to claim 10.

As an alternative for the encoder system according to claim 1, the measuring means according to the second aspect of the invention comprises a beam source, which is adapted to send a polarized beam of radiation to a first reflecting surface.

The first reflecting surface is adapted to receive the polarized beam of radiation from the beam source at an angle of substantially 45 ° and to reflect the polarized beam of radiation towards a second reflecting surface. The second reflecting surface is adapted to receive the polarized beam of radiation from the first reflecting surface at an angle of substantially 45 ° and to reflect it towards a receiving sensor. The receiving sensor is arranged at a distance from the reflecting surfaces. The receiving sensor detects -in the moveable object's z-direction- any displacement of the polarized beam of radiation reflected by the second reflecting surface relative to the receiving sensor.

The reflective surfaces can be arranged on the moveable object. In that case, the beam source and the receiving sensor are arranged at a distance from the moveable object, for example on a frame that is at least substantially stationary relative to the projection system. However, it is also possible that the beam source and the receiving sensor are arranged on the moveable object. In that case, the reflective surfaces are arranged at a distance from the moveable object, for example on a frame that is at least substantially stationary relative to the projection system.

The entrance angle of substantially 45° of the beam to each of the reflecting surfaces makes that the reflective surfaces are at a relative angle of substantially 90°. Because of this, a first beam part, which extends between the beam source and the first reflective surface and a second beam part which extends between the second reflective surface and the receiving sensor, are substantially parallel. The distance between these beam parts is determined by the position of the moveable object in the moveable object's z-direction relative to the beams source. The receiving sensor is adapted to measure changes in the distance between the first and the second beam parts, and relates these changes to displacements of the moveable object in the moveable object's z-direction.

Preferably, the receiving sensor is equipped with a grating that is touched by the second beam part. Displacement of the moveable object in the moveable object's z-direction will cause the location at which the second beam part touches the grating to move, which causes a phase shift in the thus generated first order beam (and/or minus first order beam) relative to the second beam part. From this phase shift, the displacement of the second beam part relative to the first beam part, and thus the displacement of the moveable object in the moveable object's z-direction, can be determined.

The length of the first and second reflecting surfaces is chosen such that the beam reaches them irrespective of the location of the moveable object. Preferably, the first and second reflecting surfaces extend over the entire width of the moveable object in its x-or y-direction.

As the total length of the beam is not used for determining the displacement in the moveable object's z-direction, as would be the case when using interferometers, the movements of the moveable object in its x-y-plane relative to the receiving sensor that cause a change in the total length of the beam do not affect the measurement results obtained by the measuring means.

So, by using reflective surfaces that can be reached by the beam irrespective of the position of the moveable object in the moveable object's x-y-plane, and by using a measuring principle that does not use the total length of the beam for determining the displacement of the moveable object in its z-direction, the displacement of the of the moveable object in its z-direction can be measured in spite of the movements of the moveable object in its x-y-plane.

The measuring means which is described above can be used in a lithographic apparatus for measuring the displacement of the reticle stage in the reticle stage z-direction, and for measuring the displacement of the substrate table in the substrate table z-direction, for example during projection and/or during stepping. When using this system, the displacements in z-direction can be measured accurately in spite of the far larger displacements in the y-direction or the x-y-plane.

Preferably, the beam of radiation is a laser beam.

Preferably, the beam source and the receiving sensor are accommodated in a sensor head.

According to a second further aspect of the invention, there is provided a device manufacturing method, comprising the steps of:
- providing a substrate that is at least partially covered by a layer of radiation-sensitive material;
- providing a projection beam of radiation using a radiation system;
- using patterning means to endow the projection beam with a pattern in its cross-section; and
- projecting the patterned beam of radiation onto a target portion of the layer of radiation-sensitive material;
- providing a moveable object
- moving the moveable object relative to the projection system in substantially a first direction and a second direction differing from the first direction, by using displacement means;
- measuring a displacement of the moveable object in a third direction, which is substantially perpendicular to the first direction and to the second direction by using measuring means,
characterized by
using measuring means comprising a beam source, which is adapted to send a polarized beam of radiation to a first reflecting surface, which first reflecting surface is adapted to receive the polarized beam of radiation from the beam source at an angle of substantially 45 ° and to reflect the polarized beam of radiation towards a second reflecting surface, which second reflecting surface is adapted to receive the polarized beam of radiation from the first reflecting surface at an angle of substantially 45 ° and to reflect it towards a receiving sensor which receiving sensor detects -in the third direction- any displacement of the polarized beam of radiation reflected by the second reflecting surface relative to the receiving sensor.

In a third aspect of the invention, the objects of the invention and other objects are achieved according to the invention in a lithographic apparatus according to claim 18.

When the moveable object is in its nominal position in the moveable object's z-direction, the center of the first part of beam of radiation touches the reflecting surface. The diameter of the beam of radiation is however chosen such that when the moveable object is within the expected range of variations from the nominal position, a section of the beam still touches the reflecting surface.

Radiation absorbing surfaces are arranged adjacent to the reflecting surface on both sides in the moveable object's z-direction. These radiation absorbing surfaces absorb radiation from the beam in such a way that only the section of the beam that touches the reflection surface is reflected towards the receiving sensor.

The reflecting surface and the adjacent absorbing surfaces can be arranged on the moveable object. In that case, the beam source and the receiving sensor are arranged at a distance from the moveable object. In is however also envisaged that the beam source and the receiving sensor are arranged on the moveable object. In that case, the reflecting surface and the adjacent absorbing surfaces are arranged at a distance from the moveable object.

The beam splitter directs a part of the beam towards the reflecting surface. By using a beam splitter, the beam source is not in the way of the beam returning to the receiving sensor. It is however envisaged that other ways of allowing the reflected section of the beam to reach the receiving sensor are possible.

Preferably, the receiving sensor is equipped with a grating that is touched by the reflected section of the beam. Displacement of the moveable object in the moveable object's z-direction will cause the location at which the reflected section of the beam touches the grating to move, which causes a phase shift in the thus formed first order beam (and/or minus first order beam) relative to the reflected section of the beam. From this phase shift, the displacement of the reflected section of the beam relative to the grating, and thus the displacement of the moveable object in the moveable object's z-direction, can be determined.

The measuring means which is described above can be used in a lithographic apparatus for measuring the displacement of the reticle stage in the reticle stage z-direction, and for measuring the displacement of the substrate table in the substrate table z-direction, for example during projection and/or during stepping. When using this system, the displacements in z-direction can be measured accurately in spite of the far larger displacements in the y-direction or the x-y-plane.

Preferably, the beam of radiation is a laser beam.

Preferably, the beam source and the receiving sensor are accommodated in a sensor head.

According to a third further aspect of the invention, there is provided a device manufacturing method, comprising the steps of:
- providing a substrate that is at least partially covered by a layer of radiation-sensitive material;
- providing a projection beam of radiation using a radiation system;
- using patterning means to endow the projection beam with a pattern in its cross-section; and
- projecting the patterned beam of radiation onto a target portion of the layer of radiation-sensitive material;
- providing a moveable object;
- moving the moveable object relative to the projection system in substantially a first direction and a second direction differing from the first direction, by using displacement means;
- measuring a displacement of the moveable object in a third direction, which is substantially perpendicular to the first direction and to the second direction by using measuring means,
characterized by
using measuring means comprising a beam source, which is adapted to send a polarized beam of radiation to a beam splitter, which beam splitter is adapted to direct a first part of the polarized beam of radiation from the beam source towards a reflecting surface, which reflecting surface is in the third direction adjacent to radiation absorbing surfaces for absorbing any radiation of the first part of the polarized beam that falls on them, the reflecting surface being adapted to receive a section of the first part of the polarized beam of radiation and to reflect that section of the first part of the polarized beam towards a receiving sensor, which receiving sensor detects -in the third direction- any displacement of the polarized beam of radiation reflected by the reflecting surface relative to the receiving sensor.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, LCD panels, thin-film magnetic heads, etc. The skilled artisan will appreciate that, in the context of such alternative applications, any use of the terms "reticle", "wafer", or "die" in this text should be considered as being replaced by the more general terms "mask", "substrate", or "target portion", respectively.

In the present document, the terms "radiation " and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as for example ion beams or electron beams.

Embodiments of the invention will now be described, by way of example only, with reference to the accompanying schematic drawings in which corresponding reference symbols indicate corresponding parts, and in which:
- figure 1 depicts a lithographic apparatus according to an embodiment of the invention;
- figure 2A, B show a preferred embodiment of he measuring means for measuring displacements of a substrate table or reticle stage in the its z-direction, according to the first aspect of the invention,
- figure 3 shows the beam path in the measuring means according to the first aspect of the invention,
- figure 4 shows the effect of the small angles between the first beam and the second beam and between the first beam and the third beam,
- figure 5 shows an embodiment of the measuring means according to the second aspect of the invention,
- figure 6 shows an embodiment of the measuring means according to the third aspect of the invention.

### Embodiment I

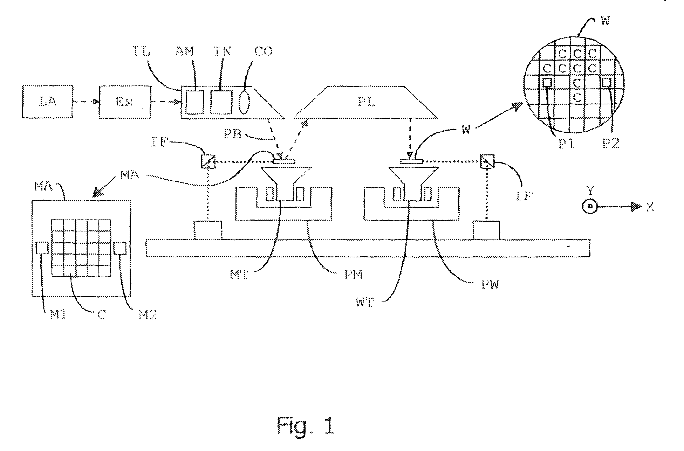

Figure 1 schematically depicts a lithographic apparatus according to a particular embodiment of the invention. The apparatus comprises:
- a radiation system Ex, IL, for supplying a projection beam PB of radiation (e.g. laser radiation). In this particular case, the radiation system also comprises a radiation source LA;
- a first object table (mask table) MT provided with a mask holder for holding a mask MA (e.g. a reticle), and connected to first positioning means PMfor accurately positioning the mask with respect to item PL;
- a second object table (substrate table) WT provided with a substrate holder for holding a substrate W (e.g. a resist-coated silicon wafer), and connected to second positioning means PWfor accurately positioning the substrate with respect to item PL; and
- a projection system ("lens') PL for imaging an irradiated portion of the mask MA onto a target portion C (e.g. comprising one or more dies) of the substrate W. As here depicted, the apparatus is of a reflective type (i.e. has a reflective mask). However, in general, it may also be of a transmissive type, for example, with a transmissive mask. Alternatively, the apparatus may employ another kind of patterning means, such as for example a programmable mirror array of a type as referred to above.

The source LA (e.g. a laser source) produces a beam of radiation. This beam is fed into an illumination system (illuminator) IL, either directly or after having traversed conditioning means, such as for example a beam expander Ex. The illuminator IL may comprise adjusting means AMfor adjusting the angular intensity distribution in the beam. Generally, at least the outer and/or inner radial extent (commonly referred to as σ-outer and σ-inner, respectively) of the intensity distribution in a pupil plane of the radiation system can be adjusted. In addition, the illuminator IL will generally comprise various other components, such as an integrator IN and a condenser CO. In this way, the beam PB impinging on the mask MA has a desired uniformity and intensity distribution in its cross-section. It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently impinges on the mask MA, which is held on a mask table MT. Reflected from the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PMcan be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is moved in a given direction (the so-called "scan direction", e.g. the y direction) with a speed v, so that the projection beam PB is caused to scan over the mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

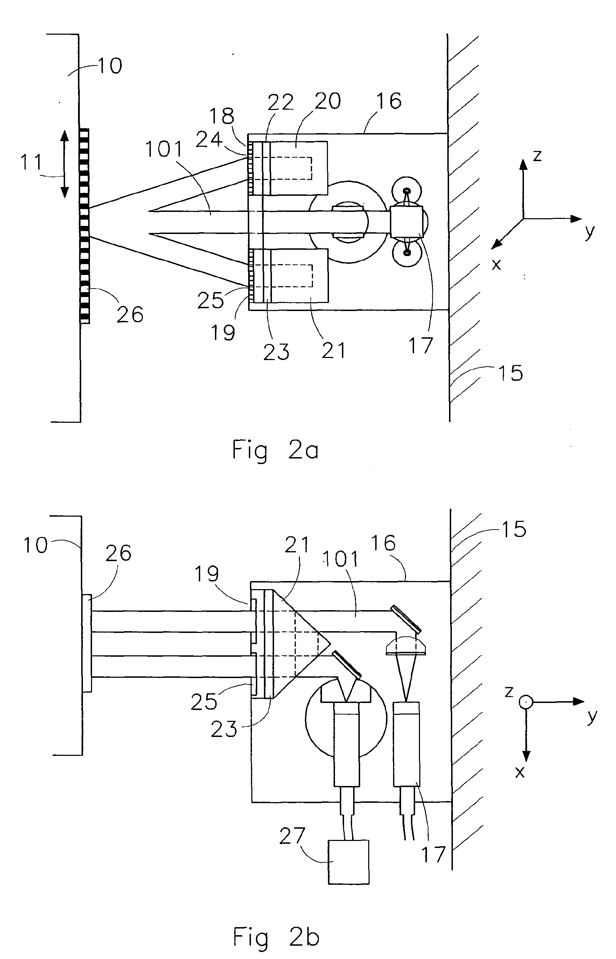

Fig. 2A, B show a preferred embodiment of he measuring means for measuring displacements of a substrate table or reticle stage 10 in the direction 11, according to the first aspect of the invention.

Onto frame 15, an encoder head 16 is mounted. In the encoder head 16 a beam source 17, a right second grating 18, a left second grating 19, a right roof prism 20, a left roof prism 21, a right λ/4-plate 22, a left λ/4-plate 23, a right third grating 24 and a left third grating 25 are accommodated. The second grating and the fourth grating are integrated in a single reflective grating 26.

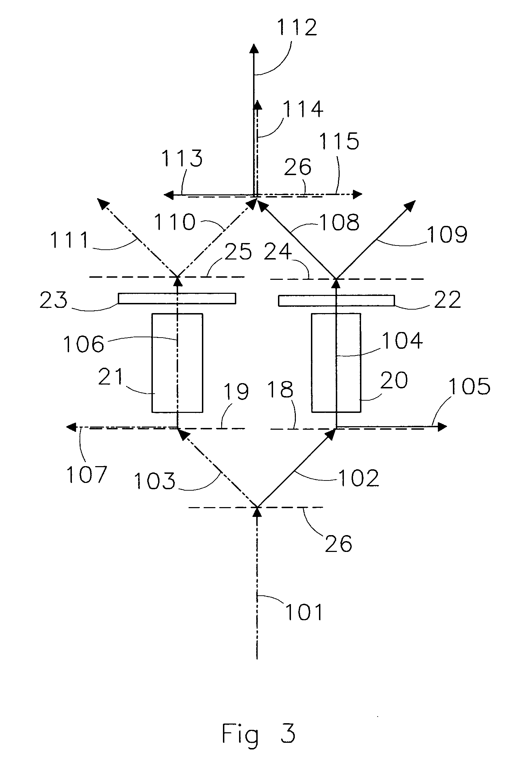

Fig. 3 shows the beam path in the measuring means according to the first aspect of the invention.

The measuring means according to the first aspect of the invention operates as follows:

A beam source 17 generates a first beam 101, which is a polarized beam of radiation such as a laser beam. The first beam 101 is directed towards the substrate table or reticle stage 10 parallel to the substrate table or reticle stage y-direction.

The first beam 101 then reaches a reflective grating 26, which is fixed onto the substrate table or reticle stage 10. The reflective grating 26 breaks the first beam 101 into at least a second beam 102, which is the first order beam of the first beam 101 and a third beam 103 which is the minus first order beam of the first beam 101. The reflective grating 26 preferably is a ruler having parallel lines parallel to the substrate table or reticle stage x-direction. Preferably, the ruler is glued to the substrate table or reticle stage.

A right second grating 18 receives the second beam 102 and breaks second beam 102 into at least a fourth beam 104, which is the first order beam of the second beam 102 and a fifth beam 105 which is the minus first order beam of the second beam 102.

A left second grating 19, adapted for receiving the third beam 103 breaks the third beam 103 into at least a sixth beam 106, which is the minus first order beam of the third beam 103 and a seventh beam 107 which is the first order beam of the third beam 103. As fig. 2A shows, the second gratings 18, 19 are arranged on opposite sides of the beam source 17. Both are transmissive gratings.

The fourth beam 104 is then directed through a right roof prism 20, which directs the fourth beam 104 in the direction opposite to the direction of the second beam 102, and at a offset distance from the second beam 102.

The sixth beam 106 is directed through a left roof prism 21, for directing the sixth beam 106 in the direction opposite to the direction of the third beam 103, and at a offset distance from the third beam 103.

Then, the fourth beam 104 passes through a right λ/4-plate 22, which is an anisotropic optical element, which turns the linear polarization of the fourth beam 104 into a circular polarization.

This sixth beam passes through a left λ/4-plate 23, which is an anisotropic optical element, which turns the linear polarization of the sixth beam 106 into a circular polarization.

A right third grating 24 receives the fourth beam 104 and breaks the fourth beam 104 into at least an eighth beam 108, which is the first order beam of the fourth beam 104 and a ninth beam 109 which is the minus first order beam of the fourth beam 104.

A left third grating 25 receives the sixth beam 106 and breaks the sixth beam 106 into at least a tenth beam 110, which is the minus first order beam of the sixth beam 106 and an eleventh beam 111 which is the first order beam of the sixth beam 106. The third gratings 24, 25 are arranged on opposite sides of the beam source 17. Each of the third gratings 24, 25 is a transmissive grating, and they are arranged aligned with the second gratings 18,19. The right second grating 18 is preferably integrated with the right third grating 24 into a single ruler. Also, the left second grating 19 is preferably integrated with the left third grating 25 into a single ruler. This way, alignment problems between the right gratings 18, 24 are prevented, as are alignment problems between the left gratings 19, 25.

The reflective grating 26 then receives the eighth beam 108 and breaks the eighth beam 108 into at least a twelfth beam 112, which is the first order beam of the eight beam and a thirteenth beam 113 which is the minus first order beam of the eighth beam 108. The reflective grating also receives the tenth beam 110 and breaks the tenth beam 110 into at least a fourteenth beam 114, which is the minus first order beam of the tenth beam 110 and a fifteenth beam 115 which is the first order beam of the tenth beam 110.

The second and third gratings 18, 19, 24, 25 are arranged such that the distance between the reflective grating 26 and the third gratings substantially equals the distance between the reflective grating 26 and the second gratings, so that the eighth beam 108 and the tenth beam 110 strike the reflective grating 26 at substantially the same location so that interference between the twelfth beam 112 and the fourteenth beam 114 occurs.

A sensor unit 27 then senses variations in radiation intensity of the interfering twelfth beam 112 and the fourteenth beam 114, and links said variations to a phase shift that occurs in the second beam 102 and in the third beam 103 relative to the first beam 101 as the first beam 101 is displaced relative to the reflective grating 26 due to displacement of the substrate table or reticle stage 10.

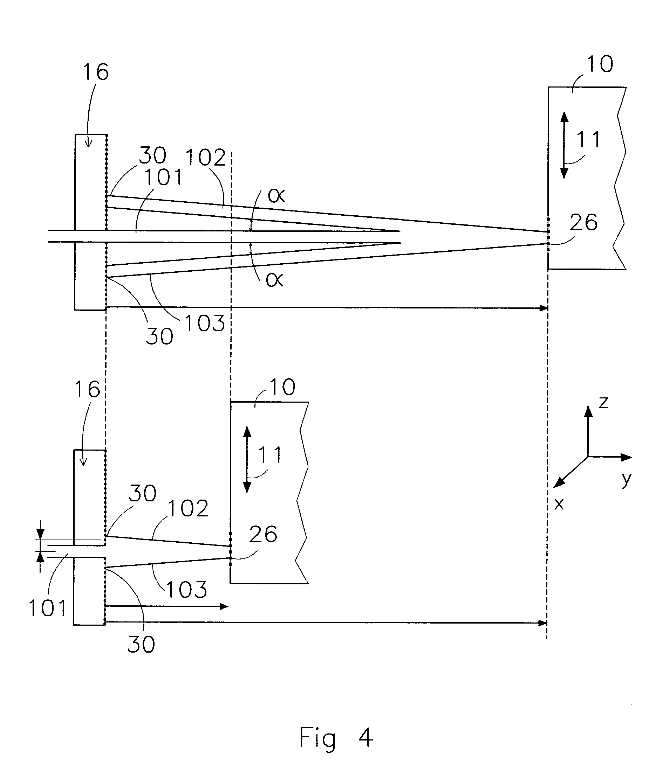

Fig. 4 shows the effect of the small angles α (preferably between 3° and 6°) between the first beam 101 and the second beam 102 and between the first beam 101 and the third beam 103. By choosing these angles a relatively small, the locations 30 where the respective beams touch the respective grating moves just a little when the substrate table or the reticle stage 10 moves in the y-direction.

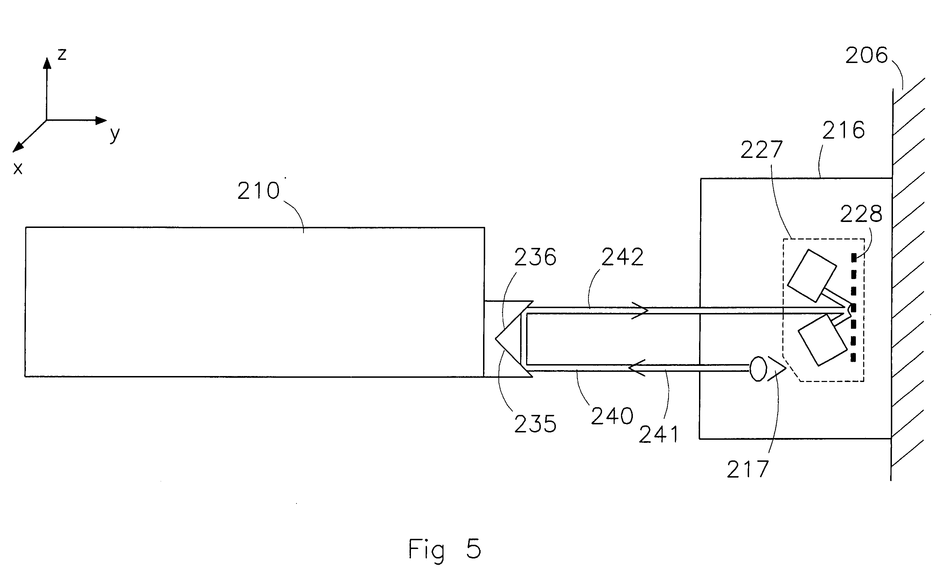

Fig. 5 shows a preferred embodiment of the measuring means according to the second aspect of the invention. A sensor head 216 comprises a beam source 217 and a receiving sensor 227. The sensor head 216 is mounted onto a fixed frame 206. The beam source 217 and the receiving sensor 227 maintain a fixed position with respect to the frame 206. Onto the substrate table or the reticle stage 210, a first reflecting surface 235 and a second reflecting surface 236 are mounted. These surfaces 235, 236 are at a respective angle of 90°.

In operation, the beam source sends a laser beam 240 in the substrate table or reticle stage y-direction to the first reflecting surface. The first reflecting surface is fixed onto the substrate table or reticle stage 210, and extends along the entire width of the substrate table or reticle stage 210 in the x-direction. It receives the laser beam from the beam source at an angle of substantially 45 ° and reflects the laser beam towards a second reflecting surface. The second reflecting surface is also fixed onto the substrate table and also extends along the entire width of the substrate table or reticle stage 210 in the x-direction. It receives the laser beam from the first reflecting surface at an angle of substantially 45 ° and reflects it towards a receiving sensor. The receiving sensor is arranged in the sensor head. The receiving sensor detects -in the substrate table or reticle stage z-direction- any displacement of the laser beam reflected by the second reflecting surface relative to the receiving sensor.

As can be seen in fig. 5, a first beam part 241, which extends between the beam source and the first reflective surface and a second beam part 242 which extends between the second reflective surface and the receiving sensor, are substantially parallel. The distance between these beam parts 241, 242 is determined by the position of the substrate table in the substrate table z-direction relative to the beam source (cf. fig. 5). The receiving sensor is adapted to measure changes in the distance between the first and the second beam parts 241, 242, and relates these changes to displacements of the substrate table in the substrate table z-direction.

Preferably, the receiving sensor is equipped with a grating 228 that is touched by the second beam part. Displacement of the substrate table in the substrate table z-direction will cause the location at which the second beam part 242 touches the grating to move, which causes a phase shift in the thus generated first order beam (and/or minus first order beam) relative to the second beam part. From this phase shift, the displacement of the second beam part relative to the first beam part, and thus the displacement of the substrate table in the substrate table z-direction, can be determined.

As can be seen in fig. 5, movements of the substrate table or reticle stage in its y-direction relative to the receiving sensor do not affect the distance between the first part of the beam 241 and the second part of the beam, so they have no influence on the measurement results obtained by the measuring means.

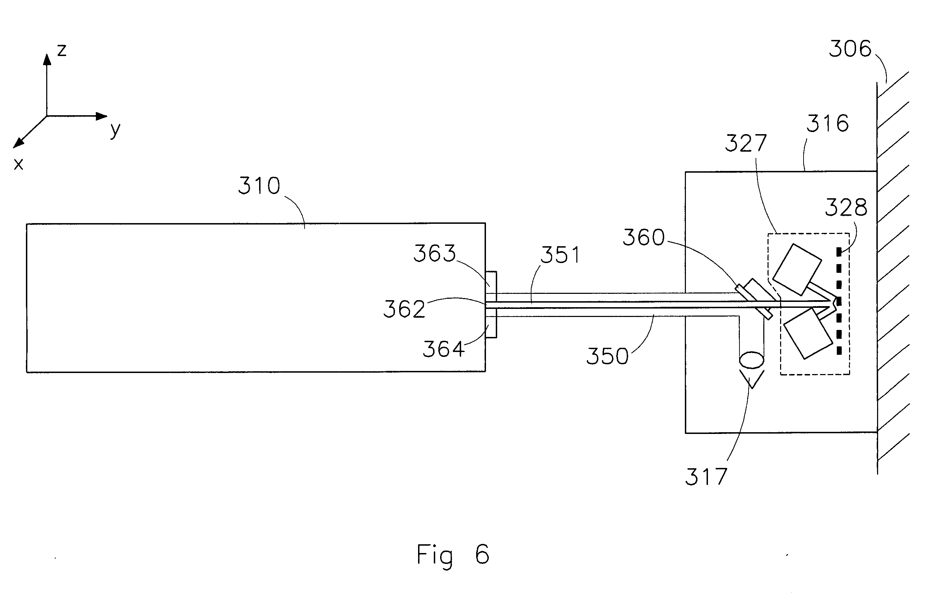

Fig. 6 shows a preferred embodiment of the measuring means according to the third aspect of the invention. A sensor head 316 comprises a beam source 317, a beam splitter 360 and a receiving sensor 327. The sensor head 316 is fixed to a frame 306. The beam source 317, the beam splitter 360 and the receiving sensor 327 maintain a fixed position with respect to the frame 306. Onto the substrate table or the reticle stage 310, a reflecting surface 362 and a two radiation absorbing surfaces 363, 364 are present.

In operation, beam source 317 sends a polarized beam of radiation, in this case a laser beam, to beam splitter 360. The beam splitter 360 directs a first part 350 of the laser beam from the beam source 317 towards reflecting surface 362 parallel to the substrate table or reticle stage 310 y-direction. The reflecting surface 362 is arranged in the substrate table or reticle stage x-direction on the substrate table or reticle stage 310, and extends over the entire width of substrate table or reticle stage 310. Adjacent to the reflecting surface 362 in the substrate table or reticle stage z-direction, radiation absorbing surfaces 363, 364 are arranged. The reflecting surface 362 receives a section of the first part 350 of the laser beam and reflects the section of the first part of the laser beam it received towards receiving sensor 327. The receiving sensor 327 detects -in the substrate table or reticle stage z direction- any displacement of the reflected section 351 of the laser beam relative to the receiving sensor.

When the substrate table or reticle stage 310 is in its nominal position in the substrate table or reticle stage z-direction, the center of the first part 350 of the laser beam touches the reflecting surface 362 on the substrate table or reticle stage 310. The diameter of the laser beam is however chosen such that when the substrate table or reticle stage 310 is within the expected range of variations from its nominal position in the substrate table or reticle stage z-direction , a section of the beam still touches the reflecting surface 362.

Radiation absorbing surfaces 363,364 are arranged adjacent to the reflecting surface 362 on both sides in the substrate table or reticle stage 310 z-direction. These radiation absorbing surfaces 363, 364 absorb any radiation from the laser beam that falls on them so that only the section of the beam that touches the reflection surface 362 is reflected towards the receiving sensor 327.

As the substrate table or reticle stage 310 moves in its z-direction, the reflective surface 362 moves along with it. This causes a change in position of the reflected section 351 of the laser beam in the substrate table or reticle stage z-direction. The displacement of the reflected laser beam section 351 is detected by the receiving sensor 327. This way, the displacement of the substrate table or reticle stage 310 in its z-direction is determined.

Preferably, the receiving sensor 327 is equipped with a grating 328 that is touched by the reflected section 351 of the laser beam. Displacement of the substrate table or reticle stage 310 in the substrate table or reticle stage z-direction will cause the location at which the reflected section 351 of the laser beam touches the grating 328 to move, which causes a phase shift in the thus formed first order beam (and/or minus first order beam) relative to the reflected section 351 of the laser beam. From this phase shift, the displacement of the reflected section 351 of the laser beam relative to the grating 328, and thus the displacement of the substrate table or reticle stage 310 in the substrate table or reticle stage z-direction, can be determined.

Whilst specific embodiments of the invention have been described above, it will be appreciated that the invention may be practiced otherwise than as described. The description is not intended to limit the invention.

## Claims

1. A lithographic apparatus comprising:
- a radiation system for providing a projection beam of radiation;
- a projection system for projecting the projection beam onto a target portion of a substrate;
- a moveable object;
- displacement means for moving the moveable object relative to the projection system in substantially a first direction and a second direction differing from the first direction;
- measuring means for measuring a displacement of the moveable object in a third direction, which is substantially perpendicular to the first direction and to the second direction,
**characterized in that**
the measuring means comprises an encoder system.

2. A lithographic apparatus according to claim 1,
**characterized in that** the encoder system comprises:
- a beam source, for generating a first beam, which is a polarized beam of radiation, which first beam is directed towards the moveable object,
- a first grating, which is fixed onto the moveable object, and which is adapted for receiving the first beam and for breaking the first beam into at least a second beam, which is the first order beam of the first beam and a third beam which is the minus first order beam of the first beam, the first grating being a reflective grating,
- a right second grating, adapted for receiving the second beam and for breaking the second beam into at least a fourth beam, which is the first order beam of the second beam and a fifth beam which is the minus first order beam of the second beam,
- a left second grating, adapted for receiving the third beam and for breaking the third beam into at least a sixth beam, which is the minus first order beam of the third beam and a seventh beam which is the first order beam of the third beam, the second gratings being arranged on opposite sides of the beam source, and each being a transmissive grating,
- a right roof prism*,* for directing the fourth beam in the direction opposite to the direction of the second beam, and at a offset distance from the second beam,
- a left roof prism, for directing the sixth beam in the direction opposite to the direction of the third beam, and at a offset distance from the third beam,
- a right λ/4-plate, which is an anisotropic optical element, for turning the linear polarization of the fourth beam into a circular polarization,
- a left λ/4-plate, which is an anisotropic optical element, for turning the linear polarization of the sixth beam into a circular polarization,
- a right third grating, adapted for receiving the fourth beam and for breaking the fourth beam into at least an eighth beam, which is the first order beam of the fourth beam and a ninth beam which is the minus first order beam of the fourth beam,
- a left third grating, adapted for receiving the sixth beam and for breaking the sixth beam into at least a tenth beam, which is the minus first order beam of the sixth beam and an eleventh beam which is the first order beam of the sixth beam, the third gratings being arranged on opposite sides of the beam source, and each being a transmissive grating, the third gratings being arranged aligned with the second gratings,
- a fourth grating, adapted for receiving the eighth beam and for breaking the eighth beam into at least a twelfth beam, which is the first order beam of the eight beam and a thirteenth beam which is the minus first order beam of the eighth beam, and adapted for receiving the tenth beam and for breaking the tenth beam into at least a fourteenth beam, which is the minus first order beam of the tenth beam and a fifteenth beam which is the first order beam of the tenth beam, the fourth grating being arranged aligned with the first grating, the fourth grating being a reflective grating and being arranged such that the distance between the fourth grating and the third grating substantially equals the distance between the first grating and the second gratings, so that the eighth beam and the tenth beam strike the fourth grating at substantially the same location so that interference between the twelfth beam and the fourteenth beam occurs,
- a sensor unit, for sensing variations in radiation intensity of the interfering twelfth beam and the fourteenth beam, and linking said variations to a phase shift that occurs in the second beam and in the third beam relative to the first beam as the first beam is displaced relative to the first grating.

3. A lithographic apparatus according to any of the preceding claims,
**characterized in that**,
the beams are laser beams.

4. A lithographic apparatus according to any of the preceding claims,
**characterized in that**,
the first grating and the fourth grating are integrated into a single ruler.

5. A lithographic apparatus according to any of the preceding claims,
**characterized in that**,
the right second grating and the right third grating are integrated into a single right ruler, and that the left second grating and the left third grating are integrated into a single left ruler.

6. A lithographic apparatus according to any of the preceding claims,
**characterized in that**,
the encoder system comprises an encoder head, in which at least the beam source, the right and left second gratings, the right and left roof prisms, the right and left λ/4-plates and the right and left third gratings are accommodated.

7. A lithographic apparatus according to any of the preceding claims,
**characterized in that**,
the angle between the first beam and the second beam and the angle between the first beam and the third beam are between 3° and 6°.

8. A lithographic apparatus according to any of the preceding claims,
**characterized in that**,
the moveable object is a substrate table.

9. A lithographic apparatus according to any of the preceding claims,
**characterized in that**,
the moveable object is a reticle stage.

10. A lithographic apparatus, comprising:
- a radiation system for providing a projection beam of radiation;
- a projection system for projecting the projection beam onto a target portion of a substrate;
- a moveable object;
- displacement means for moving the moveable object relative to the projection system in substantially a first direction and a second direction differing from the first direction;
- measuring means for measuring a displacement of the moveable object in a third direction, which is substantially perpendicular to the first direction and to the second direction,
**characterized in that**,
the measuring means comprises a beam source, which is adapted to send a polarized beam of radiation to a first reflecting surface, which first reflecting surface is adapted to receive the polarized beam of radiation from the beam source at an angle of substantially 45 ° and to reflect the polarized beam of radiation towards a second reflecting surface, which second reflecting surface is adapted to receive the polarized beam of radiation from the first reflecting surface at an angle of substantially 45 ° and to reflect it towards a receiving sensor, which receiving sensor detects -in the third direction- any displacement of the polarized beam of radiation reflected by the second reflecting surface relative to the receiving sensor.

11. A lithographic apparatus according to claim 10,
**characterized in that**,
the beam source is a laser source.

12. A lithographic apparatus according to claim 10-11,
**characterized in that**,
the receiving sensor comprises a grating which creates a phase shift in the beam of radiation when the beam moves relative to the grating.

13. A lithographic apparatus according to claim 10-12,
**characterized in that**, the beam source and the receiving sensor are accommodated in a sensor head.

14. A lithographic apparatus according to claim 10-13,
**characterized in that**
the first reflecting surface and the second reflecting surface are arranged on the moveable object, and that the beam source and the receiving sensor are arranged at a distance from the moveable object.

15. A lithographic apparatus according to claim 14,
**characterized in that**
the first reflecting surface and the second reflecting surface extend over the width of the moveable object in the first or the second direction.

16. A lithographic apparatus according to claim 10-13,
**characterized in that**
the beam source and the receiving sensor are arranged on the moveable object, and that the first reflecting surface and the second reflecting surface are arranged at a distance from the moveable object.

17. A lithographic apparatus according to claim 10-16,
**characterized in that**
the moveable object is a substrate table.

18. A lithographic apparatus according to claim 10-16,
**characterized in that**
the moveable object is a reticle stage.

19. A lithographic apparatus, comprising:
- a radiation system for providing a projection beam of radiation;
- a projection system for projecting the projection beam onto a target portion of a substrate;
- a moveable object;
- displacement means for moving the moveable object relative to the projection system in substantially a first direction and a second direction differing from the first direction;
- measuring means for measuring a displacement of the moveable object in a third direction, which is substantially perpendicular to the first direction and to the second direction,
**characterized in that**,
the measuring means comprises a beam source, which is adapted to send a polarized beam of radiation to a beam splitter, which beam splitter is adapted to direct a first part of the polarized beam of radiation from the beam source towards a reflecting surface, which reflecting surface is in the third direction adjacent to radiation absorbing surfaces for absorbing any radiation of the first part of the polarized beam that falls on them, the reflecting surface being adapted to receive a section of the first part of the polarized beam of radiation and to reflect that section of the first part of the polarized beam towards a receiving sensor, which receiving sensor detects -in the third direction- any displacement of the polarized beam of radiation reflected by the reflecting surface relative to the receiving sensor.

20. A lithographic apparatus according to claim 19,
**characterized in that**
the moveable object is a substrate table.

21. A lithographic apparatus according to claim 19,
**characterized in that**
the moveable object is a reticle stage.

22. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section; and
- projecting the patterned beam of radiation onto a target portion of the layer of radiation-sensitive material;
- providing a moveable object;
- moving the moveable object relative to the projection system in substantially a first direction and a second direction differing from the first direction, by using displacement means;
- measuring a displacement of the moveable object in a third direction, which is substantially perpendicular to the first direction and to the second direction by using measuring means,
**characterized by**
using measuring means comprising an encoder system.

23. Device manufacturing method, comprising the steps of:
- providing a substrate that is at least partially covered by a layer of radiation-sensitive material;
- providing a projection beam of radiation using a radiation system;
- using patterning means to endow the projection beam with a pattern in its cross-section; and
- projecting the patterned beam of radiation onto a target portion of the layer of radiation-sensitive material;
- providing a moveable object;
- moving the moveable object relative to the projection system in substantially a first direction and a second direction differing from the first direction, by using displacement means;
- measuring a displacement of the moveable object in a third direction, which is substantially perpendicular to the first direction and to the second direction by using measuring means,
**characterized by**
using measuring means comprising a beam source, which is adapted to send a polarized beam of radiation to a first reflecting surface, which first reflecting surface is adapted to receive the polarized beam of radiation from the beam source at an angle of substantially 45 ° and to reflect the polarized beam of radiation towards a second reflecting surface, which second reflecting surface is adapted to receive the polarized beam of radiation from the first reflecting surface at an angle of substantially 45° and to reflect it towards a receiving sensor which receiving sensor detects -in the third direction- any displacement of the polarized beam of radiation reflected by the second reflecting surface relative to the receiving sensor.

24. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section; and
- projecting the patterned beam of radiation onto a target portion of the layer of radiation-sensitive material;
- providing a moveable object;
- moving the moveable object relative to the projection system in substantially a first direction and a second direction differing from the first direction, by using displacement means;
- measuring a displacement of the moveable object in a third direction, which is substantially perpendicular to the first direction and to the second direction by using measuring means,
**characterized by**
using measuring means comprising a beam source, which is adapted to send a polarized beam of radiation to a beam splitter, which beam splitter is adapted to direct a first part of the polarized beam of radiation from the beam source towards a reflecting surface, which reflecting surface is in the third direction adjacent to radiation absorbing surfaces for absorbing any radiation of the first part of the polarized beam that falls on them, the reflecting surface being adapted to receive a section of the first part of the polarized beam of radiation and to reflect that section of the first part of the polarized beam towards a receiving sensor which receiving sensor detects -in the third direction- any displacement of the polarized beam of radiation reflected by the reflecting surface relative to the receiving sensor.

25. Measurement system for measuring displacement in a third direction, of an object which is adapted to move in a first direction and a second direction differing from the first direction, the third direction being substantially perpendicular to the first direction and to the second direction,
**characterized in that**
the measurement system comprises an encoder system.

26. Measurement system according to claim 25
**characterized in that**
the encoder system comprises:
- a beam source, for generating a first beam, which is a polarized beam of radiation, which first beam is directed towards the object,
- a first grating, which is fixed onto the object, and which is adapted for receiving the first beam and for breaking the first beam into at least a second beam, which is the first order beam of the first beam and a third beam which is the minus first order beam of the first beam, the first grating being a reflective grating,
- a right second grating, adapted for receiving the second beam and for breaking the second beam into at least a fourth beam, which is the first order beam of the second beam and a fifth beam which is the minus first order beam of the second beam,
- a left second grating, adapted for receiving the third beam and for breaking the third beam into at least a sixth beam, which is the minus first order beam of the third beam and a seventh beam which is the first order beam of the third beam, the second gratings being arranged on opposite sides of the beam source, and each being a transmissive grating,
- a right roof prism, for directing the fourth beam in the direction opposite to the direction of the second beam, and at a offset distance from the second beam,
- a left roof prism, for directing the sixth beam in the direction opposite to the direction of the third beam, and at a offset distance from the third beam,
- a right λ/4-plate, which is an anisotropic optical element, for turning the linear polarization of the fourth beam into a circular polarization,
- a left λ/4-plate, which is an anisotropic optical element, for turning the linear polarization of the sixth beam into a circular polarization,
- a right third grating, adapted for receiving the fourth beam and for breaking the fourth beam into at least an eighth beam, which is the first order beam of the fourth beam and a ninth beam which is the minus first order beam of the fourth beam,
- a left third grating, adapted for receiving the sixth beam and for breaking the sixth beam into at least a tenth beam, which is the minus first order beam of the sixth beam and an eleventh beam which is the first order beam of the sixth beam, the third gratings being arranged on opposite sides of the beam source, and each being a transmissive grating, the third gratings being arranged aligned with the second gratings,
- a fourth grating, adapted for receiving the eighth beam and for breaking the eighth beam into at least a twelfth beam, which is the first order beam of the eight beam and a thirteenth beam which is the minus first order beam of the eighth beam,
and adapted for receiving the tenth beam and for breaking the tenth beam into at least a fourteenth beam, which is the minus first order beam of the tenth beam and a fifteenth beam which is the first order beam of the tenth beam, the fourth grating being arranged aligned with the first grating, the fourth grating being a reflective grating and being arranged such that the distance between the fourth grating and the third grating substantially equals the distance between the first grating and the second gratings, so that the eighth beam and the tenth beam strike the fourth grating at substantially the same location so that interference between the twelfth beam and the fourteenth beam occurs,
- a sensor unit, for sensing variations in radiation intensity of the interfering twelfth beam and the fourteenth beam, and linking said variations to a phase shift that occurs in the second beam and in the third beam relative to the first beam as the first beam is displaced relative to the first grating.

27. Measurement system for measuring displacement in a third direction, of an object which is adapted to move in a first direction and a second direction differing from the first direction, the third direction being substantially perpendicular to the first direction and to the second direction,
**characterized in that**
the measuring system comprises a beam source, which is adapted to send a polarized beam of radiation to a first reflecting surface, which first reflecting surface is adapted to receive the polarized beam of radiation from the beam source at an angle of substantially 45 ° and to reflect the polarized beam of radiation towards a second reflecting surface, which second reflecting surface is adapted to receive the polarized beam of radiation from the first reflecting surface at an angle of substantially 45 ° and to reflect it towards a receiving sensor, which receiving sensor detects -in the third direction- any displacement of the polarized beam of radiation reflected by the second reflecting surface relative to the receiving sensor.

28. Measurement system for measuring displacement in a third direction, of an object which is adapted to move in a first direction and a second direction differing from the first direction, the third direction being substantially perpendicular to the first direction and to the second direction,
**characterized in that**
the measuring system comprises a beam source, which is adapted to send a polarized beam of radiation to a beam splitter, which beam splitter is adapted to direct a first part of the polarized beam of radiation from the beam source towards a reflecting surface, which reflecting surface is in the third direction adjacent to radiation absorbing surfaces for absorbing any radiation of the first part of the polarized beam that falls on them, the reflecting surface being adapted to receive a section of the first part of the polarized beam of radiation and to reflect that section of the first part of the polarized beam towards a receiving sensor, which receiving sensor detects -in the third direction- any displacement of the polarized beam of radiation reflected by the reflecting surface relative to the receiving sensor.
